# EUROPÄISCHE PATENTSCHRIFT

(11) **EP 2 917 748 B1**
(45) Veröffentlichungstag und Bekanntmachung des Hinweises auf die Patenterteilung: **08.01.2020**
(21) Anmeldenummer: 13830171.8
(22) Anmeldetag: 07.11.2013
(51) Int. Cl.: G01R 31/02, H05B 6/06, H05B 6/28

(54) **VERFAHREN UND VORRICHTUNG ZUM AUTOMATISCHEN ERKENNEN DER INTAKTHEIT VON ERDUNGSELEKTRODEN IM BAD EINES INDUKTIONSOFENS SOWIE INDUKTIONSOFEN**
METHOD AND DEVICE FOR AUTOMATICALLY DETECTING THE INTACTNESS OF GROUND ELECTRODES IN THE BATH OF AN INDUCTION FURNACE AND INDUCTION FURNACE
PROCÉDÉ ET DISPOSITIF DE DÉTECTION AUTOMATIQUE DE L'INTÉGRITÉ D'ÉLECTRODES DE TERRE DANS LE BAIN D'UN FOUR À INDUCTION, ET FOUR À INDUCTION CORRESPONDANT

(30) Priorität: 09.11.2012 DE 102012021904; 19.02.2013 DE 102013002797
(43) Veröffentlichungstag der Anmeldung: 16.09.2015
(73) Patentinhaber: ABP Induction Systems GmbH, 44147 Dortmund (DE)
(72) Erfinder: BARTKOWIAK, Matthias, D-44339 Dortmund (DE); FORSTHÖVEL, Christoph, D-44359 Dortmund (DE); GREEN, Daniel, Clark, NJ 07066 (US)
(74) Vertreter: Hauck Patentanwaltspartnerschaft mbB
(86) Internationale Anmeldenummer: PCT/DE2013/000663
(87) Internationale Veröffentlichungsnummer: WO 2014/071914

(56) Entgegenhaltungen:
- EP-A1- 0 291 156
- EP-A2- 0 185 887
- EP-A2- 1 818 638
- WO-A1-95/31028
- US-A- 4 293 730

## Beschreibung

Die vorliegende Erfindung betrifft ein Verfahren zum automatischen Erkennen der Intaktheit von Erdungselektroden im Bad eines Induktionsofens, der einen Induktionsofenmantel mit einer Feuerfestauskleidung und einer diese umgebenden Induktionsspule sowie eine Erdschlusserkennungseinrichtung mit mindestens einer Erdungselektrode im unteren Teil der Feuerfestauskleidung umfasst, die durch den Ofenboden führt und mit der Badschmelze in Verbindung steht.

Mit "Erkennen der Intaktheit von Erdungselektroden" ist hier auch die Erkennung der Intaktheit der elektrisch leitfähigen Verbindung zwischen den Erdungselektroden und dem Bad des Induktionsofens gemeint.

Ein typischer Induktionsofen enthält eine oder mehrere Elektroden in der unteren Feuerfestauskleidung des Ofens, um sicherzustellen, dass die Metallschmelze im Inneren des Bades geerdet ist. Die Intaktheit dieser Elektroden ist dabei ausschlaggebend für den sicheren Betrieb eines Induktionsofens, da diese eine elektrische Verbindung zwischen dem Schmelzbad und der Erdung bereitstellen. Dies ist eine notwendige Voraussetzung für den wirksamen Betrieb der Erdschlussüberwachung in einem Induktionsofen. Wird die Feuerfestauskleidung des Induktionsofens von Metallschmelze durchdrungen und kommt die Metallschmelze im Ofentiegel in Kontakt mit der Induktionsofenspule, so wird die Spule mit dem Schmelzbad und schließlich über die Erdungselektroden im Boden des Bades mit dem geerdeten Ofengestell verbunden. Auf diese Weise kann ein Erdschluss erkannt werden, wonach die Stromversorgung abgeschaltet und ein Alarm an den Ofenbediener gemeldet wird.

Aus der US 4 293 730 A sind ein Verfahren und eine Vorrichtung zur Erdschlussüberwachung bei einem elektrischen Ofen bekannt. Bei dieser Vorrichtung ist eine einzige Erdungselektrode vorgesehen, und es findet ein Strommesssensor Verwendung, der den gegen Erde fließenden Strom misst. Dies entspricht einer herkömmlichen Erdschlussüberwachung, wie sie auch im nachfolgenden Text beschrieben ist.

Aus der EP 0 185 887 A2 sind ein Verfahren und eine Vorrichtung zur Lokalisierung eines Erdschlusses an einem spulenförmigen elektrischen Leiter bekannt. Es geht hierbei um die Lokalisierung eines Erdungsfehlers zwischen einer ersten Position und einer zweiten Position an einem spulenförmigen elektrischen Leiter, wobei das Verhältnis zwischen einem ersten Spannungspotenzial und einem zweiten Spannungspotenzial gemessen wird, um die Relativposition des Fehlers zu lokalisieren. Es geht daher nicht um das automatische Erkennen der Intaktheit einer Erdungselektrode im Bad eines Induktionsofens.

Die WO 95/31028 A1 betrifft allgemein einen Detektor zur Überwachung der Integrität einer Erdungsverbindung für einen elektrischen Verbraucher. Das automatische Erkennen der Intaktheit einer Erdungselektrode ist hier ebenfalls nicht beschrieben.

Der vorliegenden Erfindung liegt die Aufgabe zugrunde, ein Verfahren der eingangs wiedergegebenen Art zu schaffen, mit dem die Betriebssicherheit eines Induktionsofens verbessert werden kann.

Diese Aufgabe wird erfindungsgemäß durch ein Verfahren der angegebenen Art gelöst, das die folgenden Schritte umfasst:
An eine weitere durch den Ofenboden führende und mit der Schmelze in Verbindung stehende isolierte Elektrode wird ein niedriger Gleich- oder Wechselstrom gelegt, der von dieser Elektrode durch das Schmelzbad zu der mindestens einen Erdungselektrode gegen Erde fließt,
nach dem Schmelzen der Charge wird dieser Strom gemessen und mit einem Bezugswert verglichen und
bei Fallen der Größe des Stromes unter den Bezugswert wird ein einen Defekt der Erdungselektrode anzeigendes Alarmsignal erzeugt.

Die vorliegende Erfindung sieht mindestens eine isoliert angebrachte Erdungselektrode, deren Erdverbindung vorzugsweise abschaltbar ausgeführt ist, und mindestens eine weitere isolierte Elektrode, die ebenfalls durch den Ofenboden führt und mit der Schmelze in Verbindung steht, vor. Ein niedriger Gleich- oder Wechselstrom wird an diese Elektrode gelegt und fließt hiervon durch das Schmelzbad zu den übrigen Elektroden gegen Erde. Wenn die Charge geschmolzen ist, wird die Größe dieses Stromes insbesondere kontinuierlich gemessen und mit einem Bezugswert verglichen, um sicherzustellen, dass der Strom über einem voreingestellten Mindestwert bleibt. Fällt die Größe dieses Stromes unter den Bezugswert, wird ein Alarmsignal erzeugt, um eine Warnung an den Ofenbediener auszugeben, dass die Erdung des Ofenschmelzbades defekt ist. Vorzugsweise wird dabei die Stromversorgung zum Ofen abgeschaltet.

Auf diese Weise wird mit dem erfindungsgemäßen Verfahren sichergestellt, dass die Erdschlusserkennungseinrichtung des Induktionsofens in der Lage ist, einen Erdschlussalarm im Fall eines Durchdringens der Metallschmelze durch die Feuerfestauskleidung des Induktionsofens bereitzustellen.

In Weiterbildung des erfindungsgemäßen Verfahrens wird mit der Erdschlusserkennungseinrichtung ermittelt, ob der Erdschluss durch ein Versagen der Feuerfestauskleidung oder durch andere Ursachen verursacht wird. Mit der Erdschlusserkennungseinrichtung wird bei Auftreten eines Erdschlusses speziell ermittelt, ob der Erdschluss außerhalb der Induktionsspule liegt oder durch Durchdringen der Metallschmelze durch die Feuerfestauskleidung zur Induktionsspule verursacht wird. Der Erdschluss wird hierbei lokalisiert, indem die mindestens eine Erdungselektrode von Erdung getrennt wird.

In Weiterbildung wird bei einem Erdschluss durch andere Ursachen festgestellt, ob der Erdschluss durch eine fehlerhafte Magnetjochisolierung verursacht wird. Dabei kann insbesondere ermittelt werden, welches Magnetjoch des Induktionsofens einen Erdschluss verursacht hat. Zur Ermittlung eines Magnetjoch-Erdschlusses werden sukzessive sämtliche Magnetjoche von Erdung getrennt.

Mit dem erfindungsgemäßen Verfahren wird somit eine verbesserte Bedienungssicherheit erreicht, da sichergestellt wird, dass ein Versagen der Erdungselektroden des Bades nicht vom Bediener unerkannt bleibt. Des Weiteren wird viel Zeit gespart, indem mit dem Verfahren automatisch die Quelle des Erdschlusses lokalisiert wird. Ein zusätzlicher Sicherheitsgewinn besteht darin, dass das Wartungspersonal im Fall eines Erdschlusses nicht kritische Zonen im Bereich des Ofens zwecks Fehlersuche aufsuchen muss. Es wird ferner das Sicherheitsrisiko beseitigt, das mit der Notwendigkeit einer Überbrückung des Erdschlussalarmes einhergeht, die typisch für vorbekannte Systeme ist, da Ursache und Art des Erdschlusses klar angezeigt werden.

Die Erfindung betrifft ferner eine Vorrichtung zur Durchführung des vorstehend beschriebenen Verfahrens, die dadurch gekennzeichnet ist, dass sie eine zusätzliche isolierte Elektrode, die durch den Ofenboden geführt ist, eine Niederspannungsquelle zum Anlegen eines niedrigen Gleich- oder Wechselstromes an die zusätzliche Elektrode, eine Einrichtung zum Messen dieses Stromes, eine Einrichtung zum Vergleichen der Größe dieses Stromes mit einem Bezugswert und eine Einrichtung zum Erzeugen eines Alarmsignals, wenn der Strom unter den Bezugswert fällt, aufweist.

Zur Lokalisierung der Quelle des Erdschlusses besitzt die Vorrichtung vorzugsweise eine Schaltvorrichtung, insbesondere ein Relais, zum Trennen der mindestens einen Erdungselektrode von Erdung.

Die Schaltvorrichtung ist vorgesehen, um automatisch festzustellen, ob der Erdschluss außerhalb der Ofenspule liegt (beispielsweise bei den Magnetjochen) oder durch Durchdringen der Metallschmelze durch die Feuerfestauskleidung zur Spule verursacht wird. Weitere Jochtrennschaltvorrichtungen trennen die Magnetjoche automatisch nacheinander, um zu ermitteln, welches Joch den externen Erdschluss verursacht hat.

Die vorliegende Erfindung betrifft ferner einen Induktionsofen mit den Merkmalen von Patentanspruch 8. Im Einzelnen bezieht sich die Erfindung hierbei auf einen Induktionsofen, der umfasst:
einen Induktionsofenmantel mit einer Feuerfestauskleidung, die zur Aufnahme einer Badschmelze ausgebildet ist,
eine Induktionsspule, die die Feuerfestauskleidung umgibt und lagert und zum induktiven Erhitzen der Badschmelze bei Anlegen eines Stromes ausgebildet ist,
eine Erdschlusserkennungseinrichtung zum Erkennen eines Erdschlusses im Induktionsofen, die mindestens eine Baderdungselektrode im unteren Teil der Feuerfestauskleidung umfasst, die durch den Ofenboden geführt ist und mit der Badschmelze in Verbindung steht.
Der Induktionsofen umfasst des Weiteren eine Vorrichtung zum automatischen Erkennen der Intaktheit von mindestens einer Baderdungselektrode, die eine zusätzliche isolierte Elektrode, die durch den Ofenboden geführt ist, eine Niederspannungsquelle zum Anlegen eines niedrigen Gleich- oder Wechselstromes an die zusätzliche isolierte Elektrode, der von der zusätzlichen isolierten Elektrode durch das Schmelzbad zu der mindestens einen Erdungselektrode gegen Erde fließt, einen Komparator zum Messen des Stromes und zum Vergleichen der Größe des Stromes mit einem Bezugswert und eine Einrichtung zum Erzeugen eines Alarmsignales, wenn der Strom unter den Bezugswert fällt, aufweist.

Die Erfindung wird nachfolgend anhand eines Ausführungsbeispieles in Verbindung mit der Zeichnung im Einzelnen erläutert. Es zeigen:
- Figur 1: eine schematische Darstellung eines Induktionsofens, der mit einer Erdschlusserkennungseinrichtung sowie mit einer Vorrichtung zum automatischen Erkennen der Intaktheit von Erdungselektroden versehen ist; und
- Figur 2: ein Ablaufdiagramm zum Lokalisieren eines Erdschlussfehlers.

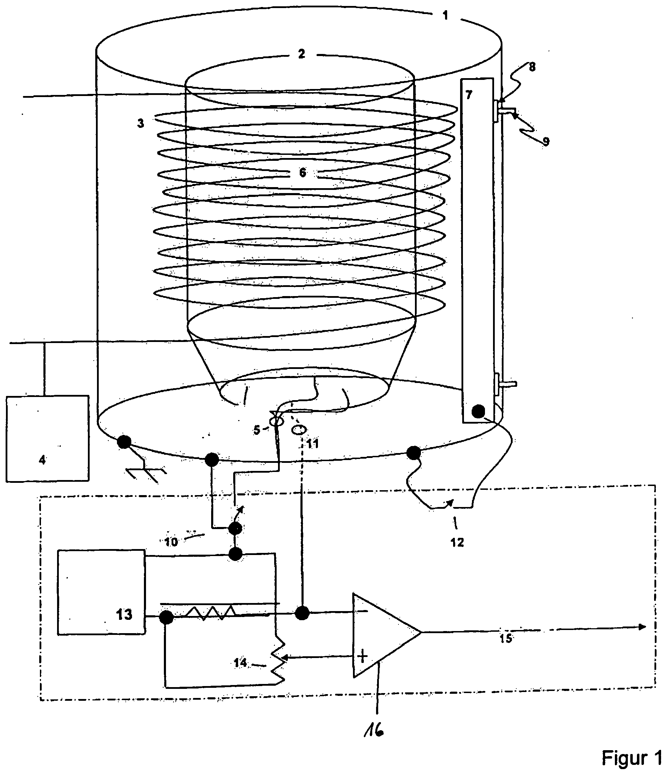

Der in Figur 1 schematisch dargestellte Induktionsofen besitzt einen Induktionsofenmantel 1, der eine Feuerfestauskleidung 2 umfasst, die von einer Induktionsspule 3 umgeben und gestützt wird. Die Feuerfestauskleidung 2 enthält ein Bad aus einer Metallschmelze, die im Induktionsofen geschmolzen wird. Die Induktionsspule 3 wird zudem von mehreren Magnetjochen 7 gestützt, die wiederum durch Isolierplatten 8 gestützt werden, welche durch Jochbolzen 9 unter Spannung gehalten werden. Die Funktion der Magnetjoche besteht darin, das Magnetfeld, das durch die Induktionsspule 3 erzeugt wird, zu führen und zu verhindern, dass es den Ofenmantel überhitzt, und die Induktionsspule 3 zudem mechanisch abzustützen.

Die Isolierplatten 8 sind zwischen den Jochen und ihren Spannbolzen angeordnet, damit ein Erdschluss, der außerhalb der Ofenspule liegt, einem spezifischen Joch zugeordnet werden kann.

Der Induktionsofen besitzt eine Erdschlusserkennungs- bzw. Überwachungseinrichtung 4, die mit der Induktionsspule 3 verbunden ist. Diese Vorrichtung (4) umfasst eine Signalquelle und einen Komparator, der den Erdungswiderstand der Induktionsspule und ihres Versorgungsstromkreises misst (in Figur 1 nicht gezeigt). Die Erdschlussüberwachung verfügt über einen Fensterkomparator mit einstellbarem oberen und unteren Grenzwert, der den gemessenen Widerstand mit oberen und unteren Schwellwerten abgleicht. Wenn der gemessene Widerstand unter den unteren Grenzwert fällt, gibt die Erdschlussüberwachung einen Alarm aus, der die Stromversorgung abschaltet und dem Bediener signalisiert, dass ein Erdschluss vorliegt. Wenn der gemessene Widerstand über den oberen Grenzwert steigt, gibt die Erdschlussmessung einen Alarm aus, der die Stromversorgung abschaltet und dem Bediener signalisiert, dass der Messkreis für den Erdungswiderstand defekt ist.

Ein solcher Erdschluss kann durch einen Schluss zwischen Spule und Erde, zwischen der Energieversorgung und Erde oder zwischen anderen spannungsführenden Teilen außerhalb der Spule und Erde entstehen. Dazu kann ein Erdschluss zur Induktionsofenspule oder Stromversorgung oder anderen spannungsführenden Komponenten gehören, die sich außerhalb der Spule befinden. Ein Spulenerdschluss kann ferner durch Durchdringen der Metallschmelze durch die Feuerfestauskleidung verursacht werden. In diesem Fall wird eine Erdverbindung durch die Erdungselektroden des Bades bereitgestellt.

Ein Problem bei bekannten Arten der Erdschlussüberwachung von Induktionsöfen besteht darin, dass es im Stand der Technik keine automatisierte Möglichkeit gibt, zu ermitteln, ob die Erdungselektroden des Bades intakt sind und/oder einen guten elektrischen Kontakt zum Schmelzbad herstellen. Dabei ist die Intaktheit dieser Verbindung eine notwendige Voraussetzung dafür, dass die Erdschlussüberwachungseinrichtung 4 feststellen kann, dass die Metallschmelze durch die Feuerfestauskleidung 2 gedrungen und mit der Induktionsspule 3 in Kontakt gekommen ist. Die Fähigkeit zur Feststellung einer solchen Durchdringung ist für den sicheren Betrieb eines Induktionsofens ausschlaggebend.

Erfindungsgemäß werden nunmehr ein Verfahren und eine Vorrichtung bereitgestellt, die automatisch prüfen, ob die Erdungselektroden intakt sind und/oder ob die elektrisch leitfähige Verbindung zwischen dem Metallschmelzbad 6 und den Erdungselektroden 5 des Bades aufrechterhalten wird. Dies wird mithilfe einer zusätzlichen isolierten Elektrode 11 erreicht, die durch den Ofenboden geführt ist. Ein niedriger Gleich- oder Wechselstrom von einer Niederspannungsquelle 13 wird durch diese Elektrode 11 durch das Schmelzbad in die übrigen Elektroden 5 gegen Erde geleitet. Die Größe dieses Stromes wird mit einem Komparator 16 gemessen und mit einem Bezugswert 14 verglichen, um sicherzustellen, dass der Strom über einem voreingestellten Mindestwert bleibt. Fällt die Größe dieses Stromes unter den Bezugswert, wird mit einer Einrichtung ein Alarmsignal 15 erzeugt, um die Stromversorgung zum Ofen abzuschalten und eine Warnung an den Ofenbediener auszugeben, dass die Erdung des Ofenschmelzbades defekt ist. Hierdurch wird sichergestellt, dass die Erdschlussmessvorrichtung des Induktionsofens in der Lage ist, einen Erdschlussalarm im Fall eines Durchdringens der Metallschmelze durch die Feuerfestauskleidung des Induktionsofens bereitzustellen.

Bei der bekannten Art der Erdschlussüberwachung besteht ferner das Problem, dass dann, wenn ein Erdschluss auftritt, der Ofen automatisch abschaltet und die Ursache manuell gesucht werden muss. Auch hierfür schafft die Erfindung Abhilfe. Wenn ein Erdschluss nach der Ofenabschaltung weiterbesteht, wird das Abschaltsignal der Erdschlusserkennungseinrichtung 4 nochmals überprüft. Hierzu ist in der Schaltung der erfindungsgemäß ausgebildeten Vorrichtung eine Schaltvorrichtung (Relais) in der Erdungsverbindung der Erdungselektrode 10 vorgesehen, die geöffnet wird, wenn der Erdschluss weiterbesteht. Wenn der Erdschluss dann nicht mehr angezeigt wird (infolge der Trennung von Erde), besteht ein Defekt in der Feuerfestauskleidung. Besteht der Erdschluss hingegen weiter, so befindet sich der Fehler außerhalb der Feuerfestauskleidung bzw. wird durch andere Ursachen erzeugt.

Weiterhin werden erfindungsgemäß ein Verfahren und eine Vorrichtung zur Verfügung gestellt, mit denen automatisch festgestellt werden kann, ob ein Erdschluss, der außerhalb des Ofens liegt, durch ein oder mehrere Magnetjoche verursacht wird, und ferner erkannt werden kann, welches spezifische Joch den Fehler verursacht. Hierzu sind entsprechende Jochtrennschaltvorrichtungen 12 (Relais) vorgesehen.

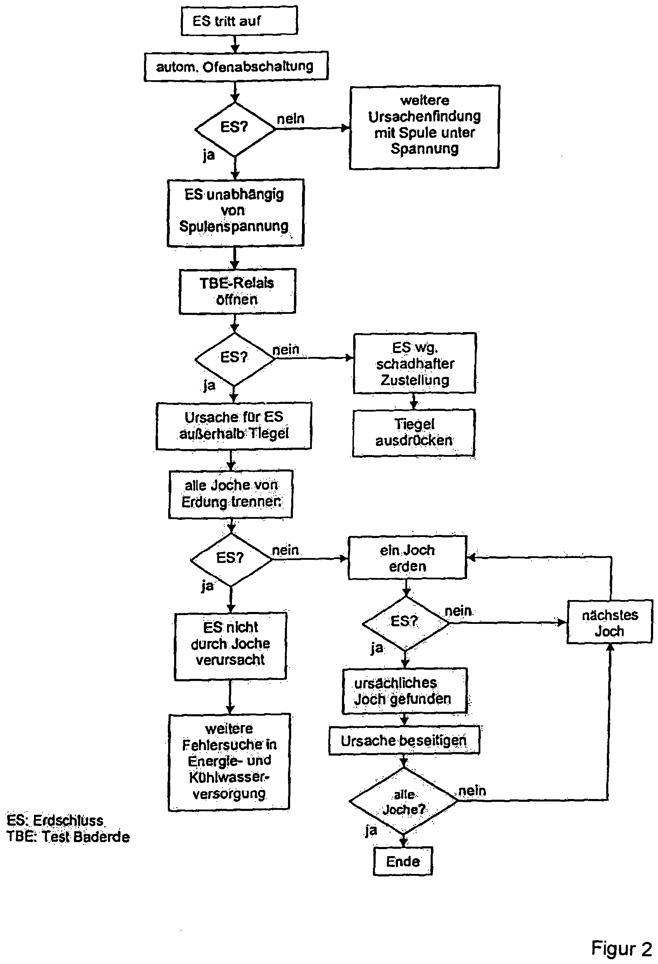

Der Verfahrensablauf zum Lokalisieren eines Erdschlussfehlers ist im Ablaufdiagramm der Figur 2 dargestellt. Läuft der Induktionsofen normal, liegen keine Erdschlüsse und Alarme vor. Die Schaltvorrichtung (Relais) 10 und die Jochschaltvorrichtungen (Relais) 12 sind geschlossen. Liegt jedoch ein Erdschluss vor, gibt das System ein Erdschlussalarmsignal aus, das die Stromversorgung zum Ofen abschaltet. Das Regelsystem öffnet sodann automatisch die Schaltvorrichtung 10. Wenn der Erdschluss nicht weiterbesteht, zeigt das System den Fehler "Defekt in der Feuerfestauskleidung" an. Wenn der Erdschluss weiterbesteht, schaltet das System die Stromversorgung kurzzeitig an, um zu prüfen, ob ein externer Erdschluss vorliegt, der nur eintritt, wenn Spannung vorhanden ist. Wenn der Erdschluss wiederkehrt, zeigt das System den Fehler "externer Erdschluss" an und öffnet anschließend sämtliche Jochtrennvorrichtungen 12 zusammen. Besteht der Erdschluss nicht weiter, zeigt das System den Fehler "Jochisolierungsfehler" an. Das System schließt anschließend sämtliche Schaltvorrichtungen 12 und öffnet die Jochtrennschaltvorrichtungen 12 automatisch nacheinander. In der Regel sind mehrere Joche (vier oder mehr) vorhanden, wobei die Menge der Jochtrennschaltvorrichtungen der Anzahl der Joche entspricht. Jedes Mal, wenn ein Jochtrennschaltvorrichtung geöffnet wird, prüft das System, ob der Erdschluss nicht mehr besteht. Wenn dies eintritt, zeigt das System eine Fehlermeldung "Isolierungsfehlung Joch Nr." an, wobei mit Nr. die Kennnummer des Jochs bezeichnet ist. Diese Testsequenz wird fortgesetzt, bis alle Joche einzeln geprüft wurden.

## Patentansprüche

1. Verfahren zum automatischen Erkennen der Intaktheit von Erdungselektroden im Bad eines Induktionsofens, der einen Induktionsofenmantel mit einer Feuerfestauskleidung und einer diese umgebenden Induktionsspule sowie eine Erdschlusserkennungseinrichtung mit mindestens einer Erdungselektrode im unteren Teil der Feuerfestauskleidung umfasst, die durch den Ofenboden führt und mit der Badschmelze in Verbindung steht, mit den folgenden Schritten:
An eine weitere durch den Ofenboden führende und mit der Schmelze in Verbindung stehende isolierte Elektrode wird ein niedriger Gleich- oder Wechselstrom gelegt, der von dieser Elektrode durch das Schmelzbad zu der mindestens einen Erdungselektrode gegen Erde fließt,
nach dem Schmelzen der Charge wird dieser Strom gemessen und mit einem Bezugswert verglichen und bei Fallen der Größe des Stromes unter den Bezugswert wird ein einen Defekt der Erdungselektrode anzeigendes Alarmsignal erzeugt.

2. Verfahren nach Anspruch 1, **dadurch gekennzeichnet, dass** bei Fallen der Größe des Stromes unter den Bezugswert die Stromversorgung für den Induktionsofen abgeschaltet wird.

3. Verfahren nach Anspruch 1 oder 2, **dadurch gekennzeichnet, dass** mit der Erdschlusserkennungseinrichtung bei Auftreten eines Erdschlusses ermittelt wird, ob der Erdschluss durch andere Ursachen oder durch Durchdringen der Metallschmelze durch die feuerfeste Auskleidung zur Induktionsspule verursacht wird, indem die mindestens eine Erdungselektrode von Erdung getrennt wird.

4. Verfahren nach Anspruch 3, **dadurch gekennzeichnet, dass** bei einem Erdschluss durch andere Ursachen festgestellt wird, ob der Erdschluss durch eine fehlerhafte Magnetjochisolierung verursacht wird, wobei ermittelt wird, welches Magnetjoch des Induktionsofens einen Erdschluss verursacht hat, indem sukzessive sämtliche Magnetjoche von Erdung getrennt werden.

5. Vorrichtung zur Durchführung des Verfahrens nach einem der vorangehenden Ansprüche, **dadurch gekennzeichnet, dass** sie eine zusätzliche isolierte Elektrode (11), die durch den Ofenboden geführt ist, eine Niederspannungsquelle (13) zum Anlegen eines niedrigen Gleich- oder Wechselstromes an die zusätzliche Elektrode (11), eine Einrichtung zum Messen dieses Stromes, eine Einrichtung zum Vergleichen der Größe dieses Stromes mit einem Bezugswert (14) und eine Einrichtung (15) zum Erzeugen eines Alarmsignals, wenn der Strom unter den Bezugswert (14) fällt, aufweist.

6. Vorrichtung nach Anspruch 5, **dadurch gekennzeichnet, dass** sie eine Schaltvorrichtung zum Trennen der mindestens einen Erdungselektrode von Erdung aufweist.

7. Vorrichtung nach Anspruch 5 oder 6, **dadurch gekennzeichnet, dass** sie eine Jochtrennschaltvorrichtung (12) aufweist.

8. Induktionsofen mit
einem Induktionsofenmantel (1) mit einer Feuerfestauskleidung (2), die zur Aufnahme einer Badschmelze ausgebildet ist,
einer Induktionsspule (3), die die Feuerfestauskleidung (2) umgibt und lagert und zum induktiven Erhitzen der Badschmelze bei Anlegen eines Stromes ausgebildet ist,
einer Erdschlusserkennungseinrichtung (4) zum Erkennen eines Erdschlusses im Induktionsofen, die mindestens eine Baderdungselektrode (5) im unteren Teil der Feuerfestauskleidung (2) umfasst, die durch den Ofenboden geführt ist und mit der Badschmelze in Verbindung steht, und
einer Vorrichtung zum automatischen Erkennen der Intaktheit von mindestens einer Baderdungselektrode (5), die aufweist:
eine zusätzliche isolierte Elektrode (11), die durch den Ofenboden geführt ist,
eine Niederspannungsquelle (13) zum Anlegen eines niedrigen Gleich- oder Wechselstromes an die zusätzliche isolierte Elektrode (11), der von der zusätzlichen isolierten Elektrode (11) durch das Schmelzbad zu der mindestens einen Erdungselektrode (5) gegen Erde fließt,
einen Komparator (16) zum Messen des Stromes und zum Vergleichen der Größe des Stromes mit einem Bezugswert (14) und
eine Einrichtung (15) zum Erzeugen eines Alarmsignales, wenn der Strom unter den Bezugswert (14) fällt.

## Claims

1. A method for automatically detecting the intactness of ground electrodes in the bath of an induction furnace that has an induction furnace jacket with a refractory lining and an induction coil surrounding the jacket as well as a ground fault detector with at least one bath ground electrode in the lower part of the refractory lining that extends through the furnace bottom and is in connection with the bath melt, comprising the following steps:
Applying a low DC or AC current to an additional insulated electrode extending through the furnace bottom and in connection with the bath melt, the current flowing from this electrode through the bath melt to the at least one bath ground electrode to ground,
after melting of the charge, measuring this current and comparing the measured current with a reference value, and
generating an alarm signal indicating a defect of the bath ground electrode when the magnitude of the current drops below the reference value.

2. The method according to claim 1, **characterized by** switching off the current supply for the induction furnace when the magnitude of the current drops below the reference value.

3. The method according to claim 1 or 2, **characterized by** ascertaining with the ground fault detector upon the occurrence of a ground fault whether the ground fault is caused by other reasons or by penetration of the metal melt through the refractory lining to the induction coil by separating the at least one bath ground electrode from ground.

4. The method according to claim 3, **characterized by**, if a ground fault by other reasons is detected, detecting whether the ground fault is caused by a defective magnetic yoke insulation wherein it is ascertained which magnetic yoke of the induction furnace has caused a ground fault by separating successively all the magnetic yokes from ground.

5. An apparatus for carrying out the method according to one of the preceding claims, **characterized in that** it has an additional insulated electrode (11) which extends through the furnace bottom, a low-voltage source (13) for applying a low DC or AC current to the additional electrode (11), means for measuring this current, means for comparing the magnitude of this current with a reference value (14), and means (15) for generating an alarm signal when the current drops below the reference value (14) .

6. The apparatus according to claim 5, **characterized in that** it has a switching device for separating the at least one bath ground electrode from ground.

7. The apparatus according to claim 5 or 6, **characterized in that** it has a yoke separating device (12).

8. An induction furnace comprising
an induction furnace jacket (1) with a refractory lining (2) for receiving a bath melt,
an induction coil (3) surrounding the refractory lining (2) and designed for inductively heating the bath melt when a current is applied,
a ground fault detector (4) for detecting a ground fault in the induction furnace which has at least one bath ground electrode (5) in the lower part of the refractory lining (2) which extends through the furnace bottom and is in connection with the bath melt, and
an apparatus for automatically detecting the intactness of at least one bath ground electrode (5) including:
an additional insulated electrode (11) extending through the furnace bottom,
a low-voltage source (13) for applying a low DC or AC current to the additional insulated electrode (11) that flows from the additional insulated electrode (11) through the melt bath to the at least on ground electrode (5) to ground,
a comparator (16) for measuring the current and for comparing the magnitude of the current with a reference value (14) and
means (15) for generating an alarm signal when the current drops below the reference value (14).

## Revendications

1. Procédé de détection automatique de l'intégrité d'électrodes de terre dans le bain d'un four à induction, qui comprend une enveloppe de four à induction avec un revêtement réfractaire et une bobine d'induction entourant celui-ci ainsi qu'un appareil de détection de mise à la terre avec au moins une électrode de terre dans la partie inférieure du revêtement réfractaire, qui guide à travers le fond de four et communique avec la matière fondue de bain, avec les étapes suivantes :
un faible courant continu ou alternatif, qui circule de cette électrode à travers le bain de fusion vers l'au moins une électrode de terre contre la terre, est appliqué sur une autre électrode isolée guidant à travers le fond de four et communiquant avec la matière fondue,
après la fusion de la charge, ce courant est mesuré et comparé avec une valeur de référence et
dans les cas où la grandeur du courant est sous la valeur de référence, un signal d'alarme indiquant un défaut de l'électrode de terre est généré.

2. Procédé selon la revendication 1, **caractérisé en ce que** dans les cas où la grandeur du courant est sous la valeur de référence, l'alimentation en courant pour le four à induction est coupée.

3. Procédé selon la revendication 1 ou 2, **caractérisé en ce que** lors de l'apparition d'une mise à la terre, il est déterminé avec l'appareil de détection de mise à la terre si la mise à la terre est provoquée par d'autres causes ou par pénétration du métal fondu à travers le revêtement réfractaire vers la bobine d'induction, par le fait que l'au moins une électrode de terre est coupée de la terre.

4. Procédé selon la revendication 3, **caractérisé en ce que** lors d'une mise à la terre par d'autres causes, il est constaté si la mise à la terre est provoquée par un défaut d'isolation de la culasse magnétique, dans lequel il est déterminé quelle culasse magnétique du four à induction a provoqué une mise à la terre, par le fait que progressivement toutes les culasses magnétiques sont coupées de la terre.

5. Dispositif de réalisation du procédé selon l'une quelconque des revendications précédentes, **caractérisé en ce qu'**il présente une électrode isolée supplémentaire (11), qui est guidée à travers le fond de four, une source de basse tension (13) pour l'application d'un faible courant continu ou alternatif sur l'électrode supplémentaire (11), un appareil de mesure de ce courant, un appareil de comparaison de la grandeur de ce courant avec une valeur de référence (14) et un appareil (15) de génération d'un signal d'alarme, lorsque le courant tombe sous la valeur de référence (14).

6. Dispositif selon la revendication 5, **caractérisé en ce qu'**il présente un dispositif de commutation pour couper au moins une électrode de terre de la terre.

7. Dispositif selon la revendication 5 ou 6, **caractérisé en ce qu'**il présente un dispositif de coupure de culasse (12).

8. Four à induction avec
une enveloppe de four à induction (1) avec un revêtement réfractaire (2), qui est réalisé pour la réception d'une matière fondue de bain,
une bobine d'induction (3), qui entoure et loge le revêtement réfractaire (2) et est réalisée pour le chauffage par induction de la matière fondue de bain lors de l'application d'un courant,
un appareil de détection de mise à la terre (4) pour la détection d'une mise à la terre dans le four à induction, qui comprend au moins une électrode de terre de bain (5) dans la partie inférieure du revêtement réfractaire (2), qui est guidée à travers le fond de four et communique avec la matière fondue de bain, et
un dispositif de détection automatique de l'intégrité d'au moins une électrode de terre de bain (5), qui présente :
une électrode isolée supplémentaire (11), qui est guidée à travers le fond de four,
une source de basse tension (13) pour l'application d'un faible courant continu ou alternatif sur l'électrode isolée supplémentaire (11), qui circule de l'électrode isolée supplémentaire (11) à travers le bain de fusion vers l'au moins une électrode de terre (5) contre la terre,
un comparateur (16) pour la mesure du courant et pour la comparaison de la grandeur du courant avec une valeur de référence (14) et
un appareil (15) de génération d'un signal d'alarme, lorsque le courant tombe sous la valeur de référence (14).
